# EUROPEAN PATENT APPLICATION

(11) **EP 4 333 256 A1**
(43) Date of publication of application: **06.03.2024**
(21) Application number: 23809070.8
(22) Date of filing: 28.06.2023
(51) Int. Cl.: H02J 9/06

(54) **SOLID-STATE AUTOMATIC TRANSFER SWITCH AND OPERATION METHOD THEREFOR**

(30) Priority: 30.06.2022 CN 202210771226
(71) Applicant: Schneider Electric Industries SAS, 92500 Rueil Malmaison (FR)
(72) Inventor: CHEN, Xiaohang, Shanghai 201203 (CN); ZHAO, Haijun, Shanghai 201203 (CN); SHI, Ying, Shanghai 201203 (CN); CHEN, Jiamin, Shanghai 201203 (CN); SONG, Yangfeng, Shanghai 201203 (CN); YANG, Qing, Shanghai 201203 (CN); LI, Yuxia, Shanghai 201203 (CN); ZHANG, Kunpeng, Shanghai 201203 (CN); ZHANG, Kunpeng, Shanghai 201203 (CN)
(74) Representative: Manitz Finsterwald Patent- und Rechtsanwaltspartnerschaft mbB
(86) International application number: PCT/CN2023/103136
(87) International publication number: WO 2024/002148

(57) **Abstract**

A solid-state automatic transfer switch and an operating method thereof is provided. The solid-state automatic transfer switch may include: a first input terminal, configured to input a first power supply; a second input terminal, configured to input a second power supply; a power supply gating module, including a solid-state switch and configured to gate one of the first power supply and the second power supply as a current gated power supply; an isolation & inverter module, configured to generate an isolation & inverter power supply based on control of a control module; a control module, configured to detect a circuit state and control, based on a result of the detecting, switching of the current gated power supply by the power supply gating module; and a power supply output terminal, configured to output at least one of the current gated power supply and the isolation & inverter power supply.

## Description

### CROSS-REFERENCE TO RELATED APPLICATION(S)

This application claims priority of the Chinese Patent Application No. 202210771226.6 filed on June 30, 2022, the content disclosed in which is incorporated herein by reference in their entities.

### TECHNICAL FIELD

The present disclosure relates to a technical field of circuit system, and more particularly, to a solid-state automatic transfer switch and an operating method thereof.

### BACKGROUND

A traditional dual-power transfer switch (for example, Automatic Transfer Switch (ATS)) is of a simple mechanical structure. Due to the inherent shortcomings of a mechanical structure, a switching time of a traditional ATS is often longer than 100ms. For some devices (or loads) that are sensitive to power-off time, such an interrupted time is often unacceptable. Therefore, for such loads, a traditional ATS cannot complete the power switching work independently, and often need to cooperate with an Uninterruptible Power Supply (UPS) to meet a demand of uninterrupted power supplying, thus increasing the complexity of the system and the cost of building the whole system. In order to solve this shortcoming, the traditional ATS is optimized by a Solid-State ATS (SSATS), which adds a power electronic inverter power electronic device on the basis of a traditional ATS. During the switching, the power electronic device supplies power to the downstream loads, thus greatly reducing the power-off time of the lower-stage loads, thus meeting a demand of high-continuous power supplying for the loads. However, the traditional ATS only involves operations of mechanical parts, while in addition to the mechanical parts, the solid-state ATS further has electrical parts to cooperate with them. For example, it is necessary to know when to switch the power supply or how to switch. Therefore, an efficient electrical operation logic or operating method is needed to support operations of a solid-state ATS.

### SUMMARY

### TECHNICAL PROBLEMS

The traditional ATS only involves operations of mechanical parts, while in addition to the mechanical parts, the solid-state ATS further has electrical parts to cooperate with them. For example, it is necessary to know when to switch the power supply or how to switch. Therefore, an efficient electrical operation logic or operating method is needed to support operations of a solid-state ATS.

### SOLUTION TO THE PROBLEMS

Embodiments of the present disclosure provide a solid-state automatic transfer switch, including: a first input terminal, configured to input a first power supply; a second input terminal, configured to input a second power supply; a power supply gating module, including a solid-state switch and configured to gate one of the first power supply and the second power supply as a current gated power supply; an isolation & inverter module, configured to generate an isolation & inverter power supply based on control of a control module; a control module, configured to detect a circuit state and control, based on a result of the detecting, switching of the current gated power supply by the power supply gating module; and a power supply output terminal, configured to output at least one of the current gated power supply and the isolation & inverter power supply based on control of the control module.

Embodiments of the present disclosure provide an operating method of a solid-state automatic transfer switch which includes a first input terminal, a second input terminal, a power supply gating module, an isolation & inverter module, a control module and a power supply output terminal, the operating method including: gating one of a first power supply input through the first input terminal and a second power supply input through the second input terminal as a current gated power supply by the power supply gating module; detecting a circuit state by the control module; controlling, by the control module and based on a result of the detecting, the isolation & inverter module to generate an isolation & inverter power supply; controlling, by the control module and based on a result of the detecting, switching of the current gated power supply by the power supply gating module; and controlling, by the control module and based on a result of the detecting, the power supply output terminal to output at least one of the current gated power supply and the isolation & inverter power supply.

### EFFECTS OF THE PRESENT DISCLOSURE

Embodiments of the present disclosure provide a solid-state automatic transfer switch and an efficient operating method thereof. According to embodiments of the present disclosure, by detecting a circuit state and controlling operations of a solid-state automatic transfer switch based on a result of the detecting, it can be clear when to switch the power supply or how to switch, thus realizing an efficient operation logic of the solid-state ATS.

### BRIEF DESCRIPTION OF DRAWINGS

The above and other aspects, features and advantages of certain embodiments of the present disclosure will be more apparent from the following description taken in conjunction with the drawings, in which:
FIG. 1 shows a schematic diagram of a solid-state automatic transfer switch (SSATS) according to embodiments of the present disclosure;
FIG. 2 shows an example structure of a solid-state automatic transfer switch according to embodiments of the present disclosure;
FIG. 3 shows a schematic diagram of a power-supplying loop of a solid-state automatic transfer switch when overload is detected according to embodiments of the present disclosure;
FIG. 4 shows an example change process of a load voltage during power switching according to embodiments of the present disclosure;
FIG. 5 shows an example flowchart of a power switching process according to embodiments of the present disclosure; and
FIG. 6 shows a flowchart of an operating method of a solid-state automatic transfer switch according to embodiments of the present disclosure.

### DETAILED DESCRIPTION

Before proceeding to the following detailed description, it may be beneficial to set forth the definitions of certain words and phrases used throughout this patent document. The terms "couple", "connect" and their derivatives refer to any direct or indirect communication or connection between two or more elements, regardless of whether those elements are in physical contact with each other. The terms "transmission", "reception" and "communication" and their derivatives encompass direct and indirect communication. The terms "include" and "contain" and their derivatives refer to including but not limited to. The term "or" is inclusive, which means and/or. The phrases "associated with", "corresponding to" and their derivatives refer to including, being included in, interconnecting, containing, being contained in, connecting to or connecting with, coupling to or coupling with, communicating with, cooperating with, interweaving, juxtaposing, approaching, binding to or binding with, having, having a property of, having a relationship or having a relationship with, etc. The term "controller" refers to any device, system or part thereof that controls at least one operation. Such a controller may be implemented in hardware or a combination of hardware and software and/or firmware. The functions associated with any particular controller can be centralized or distributed, whether local or remote. The phrase "at least one", when used with a list of items, means that different combinations of one or more of the listed items can be used, and it may be that only one item in the list is needed. For example, "at least one of A, B and C" includes any one of the following combinations: A, B, C, A and B, A and C, B and C, A and B and C.

Definitions of other specific words and phrases are provided throughout this patent document. It should be understood by those skilled in the art that in many cases, if not most cases, these definitions also apply to the previous and future uses of words and phrases so defined.

In this patent document, the application combination of modules and the division hierarchy of sub-modules are only used for illustration, and the application combination of modules and the division hierarchy of sub-modules may have different ways without departing from the scope of the present disclosure. Embodiments of the present disclosure may be implemented in different forms and should not be construed as limited to the embodiments set forth herein. Rather, these embodiments are provided so that the present disclosure will be thorough and complete, and will fully convey exemplary implementations to those skilled in the art. Embodiments of the present disclosure may be combined to form further embodiments.

The present disclosure will be described in detail below with reference to exemplary embodiments thereof. However, the present disclosure is not limited to the embodiments described herein, and it may be implemented in many different forms. The described embodiments are only used to make the present disclosure thorough and complete, and fully convey the concept of the present disclosure to those skilled in the art. Features of the described embodiments may be combined or substituted with each other unless explicitly excluded or should be excluded according to the context.

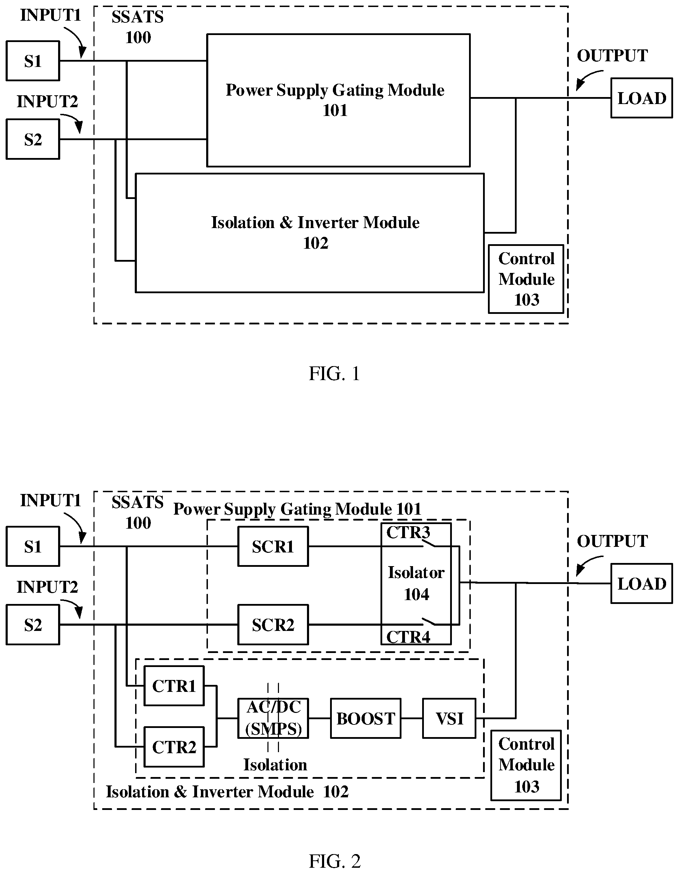

FIG. 1 shows a schematic diagram of a solid-state automatic transfer switch (SSATS)100 according to embodiments of the present disclosure.

As shown in FIG. 1, taking a dual-power switching scenario as an example, the solid-state automatic transfer switch 100 according to embodiments of the present disclosure may include a first input terminal INPUT1, a second input terminal INPUT2, a power supply gating module 101, an isolation & inverter module 102, a control module 103 and a power supply output terminal OUTPUT. In some embodiments, the first input terminal INPUT1 may be configured to input a first power supply S1. In some embodiments, the second input terminal INPUT2 may be configured to input a second power supply S2. In some embodiments, the power supply gating module 101 may include a solid-state switch (which will be described below) and may be configured to gate one of the first power supply S1 and the second power supply S2 as a current gated power supply through the solid-state switch. In some embodiments, the isolation & inverter module 102 may be configured to generate an isolation & inverter power supply based on control of a control module 103. In some embodiments, depending on the control of the control module 103, the isolation & inverter power supply may be at least one of a first isolation & inverter power supply and a second isolation & inverter power supply, which will be described in detail below. In some embodiments, the control module 103 may be configured to detect a state of a circuit where the solid-state automatic transfer switch 100 is located, and control the power supply gating module 101 to switch the current gated power supply based on a result of the detecting. In some embodiments, the power supply output terminal OUTPUT may be configured to output at least one of the current gated power supply currently gated by the power supply gating module 101 and the isolation & inverter power supply generated by the isolation & inverter module 102 based on control of the control module 103.

In some embodiments, the control module 103 may detect a voltage state of the current gated power supply (for example, one of S1 or S2, hereinafter it is assumed that the current gated power supply is S1) currently gated by the power supply gating module 101. When it is detected that one or more of overvoltage, undervoltage, power-off or frequency exceeding a first threshold occurs on the current gated power supply, the control module 103 may control the power supply gating module 101 to switch the current gated power supply from one of the first power supply S1 and the second power supply S2 that is currently gated (e.g., S1) to one of the first power supply S1 and the second power supply S2 that is not currently gated (e.g., S2).

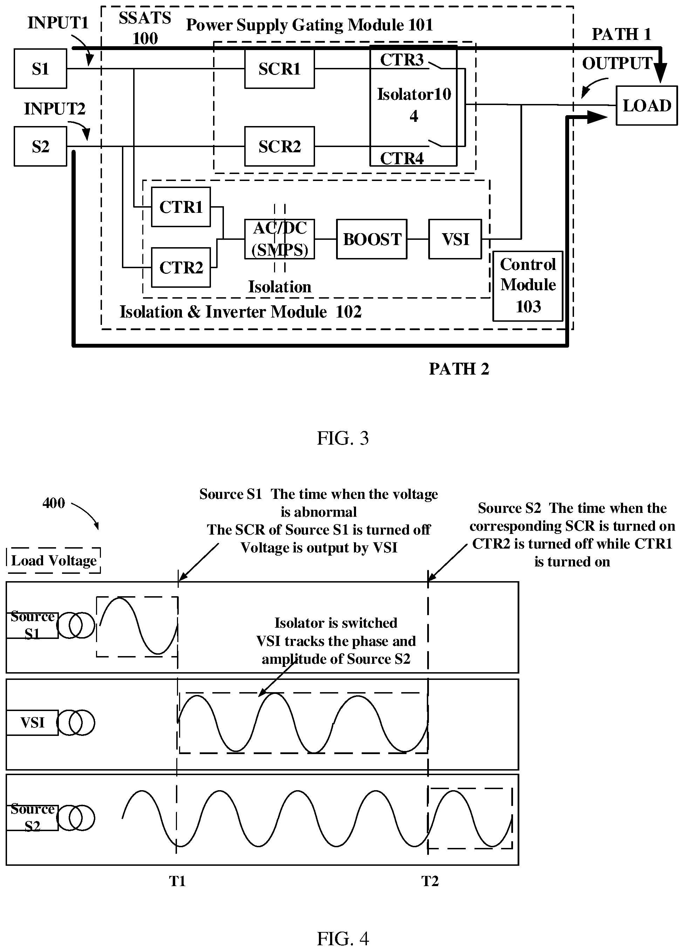

In some embodiments, the control module 103 may detect a load state of the current gated power supply (for example, one of S1 or S2, hereinafter, it is assumed that the current gated power supply is S1) currently gated by the power supply gating module 101. When it is detected that the current gated power supply is overloaded and a degree of overload is lower than a second threshold (for example, overload < 200%), the control module 103 may control the power supply gating module 101 to maintain the current gated power supply (e.g., S1), and control the isolation & inverter module 102 to generate a first isolation & inverter power supply for eliminating the overload. In this case, the current gated power supply (e.g., S1) and the first isolation & inverter power supply may be jointly output through the power supply output terminal OUTPUT to supply power to the load LOAD (as shown in the following FIG. 3). According to embodiments of the present disclosure, in order to eliminate the overload, the first isolation & inverter power supply may be generated by the isolation & inverter module 102 in a current source mode.

In some embodiments, a first circuit breaker (e.g., an air breaker) may be further provided between the first input terminal INPUT1 and the first power supply S1, and a second circuit breaker (e.g., an air breaker) may be further provided between the power supply output terminal OUTPUT and a load LOAD. In this case, the control module 103 may detect a current state of the current gated power supply (e.g., S1) currently gated by the power supply gating module 101. When it is detected that an operating current of the current gated power supply is greater than a third threshold (for example, a threshold corresponding to a short-circuit current) and/or a change speed of the operating current is greater than a fourth threshold (for example, a threshold corresponding to a change speed of a short-circuit current), the control module 103 may control the power supply gating module 101 to maintain the current gated power supply (e.g., S1), and protect the circuit by, for example, disconnecting of at least one of the first circuit breaker and the second circuit breaker.

In some embodiments, the control module 103 may further be configured to, for example, receive a switching instruction from a user, and control the power supply gating module 101 to switch the current gated power supply from one of the first power supply S1 and the second power supply S2 that is currently gated (e.g., S1) to one of the first power supply S1 and the second power supply S2 that is not currently gated (e.g., S2) based on the switching instruction.

In some embodiments, the control module 103 may further be configured to control, during a switching process of the current gated power supply, the power supply gating module 101 to turn off the gating of the current gated power supply (e.g., S1) and control the isolation & inverter module 102 to generate a second isolation & inverter power supply for supplying power to the load LOAD during the switching process.

In some embodiments, an initial voltage amplitude of the second isolation & inverter power supply generated by the isolation & inverter module 102 during the switching process may be slightly higher than the voltage amplitude of the current gated power supply (e.g., S1), so as to prompt the solid-state switch connected to the first input terminal INPUT1 included in the power supply gating module 101 to quickly enter a turn-off state. It should be understood that according to specific implementations, the initial voltage amplitude of the second isolation & inverter power supply generated by the isolation & inverter module 102 during the switching process may also be equal to or lower than the voltage amplitude of the current gated power supply (e.g., S1), which is not limited herein. In addition, the voltage amplitude of the second isolation & inverter power supply may be gradually adjusted to be the same as the voltage amplitude of an input power supply to be switched to (e.g., S2).

In some embodiments, an initial phase of the second isolation & inverter power supply generated by the isolation & inverter module 102 during the switching process may be the same as a phase of the current gated power supply (e.g., S1), so as to ensure the continuity of load power supply. In addition, during the switching process, the phase of the second isolation & inverter power supply may be slowly adjusted (for example, at a first rate) to be the same as the phase of an input power supply to be switched to (e.g., S2).

In some embodiments, the control module 103 may be further configured to control the power supply gating module 101 to gate an input power supply to be switched to (e.g., S2) when the voltage amplitude of the second isolation & inverter power supply is the same as the voltage amplitude of the input power supply to be switched to (e.g., S2) and the phase of the second isolation & inverter power supply is the same as the phase of the input power supply to be switched to (e.g., S2), and control the isolation & inverter module 102 to terminate the output of the second isolation & inverter power supply. At this time, the switching process of the solid-state automatic transfer switch 100 is completed, and the output power supply of the solid-state automatic transfer switch 100 is successfully switched from the first power supply S1 to the second power supply S2.

Next, FIG. 2 shows an example structure of a solid-state automatic transfer switch 100 according to embodiments of the present disclosure. Embodiments of the present disclosure are further described below with reference to FIG. 2.

As shown in FIG. 2, firstly, S1 and S2 may be two mains power supplies (for example, voltage source or current source) for supplying power to the load, which may be connected to the first input terminal INPUT1 and the second input terminal INPUT2 of the solid-state automatic transfer switch 100 respectively.

In the embodiment shown in FIG. 2, the power supply gating module 101 may include two solid-state switches (for example, thyristors SCR1 and SCR2) and an isolator 104. In some embodiments, the isolator 104 may further include two mechanical switches, such as CTR3 and CTR4. Thyristors SCR1 and SCR2 may be used for fast turn-off between power supply and load. Isolator 104 (or mechanical switches CTR3 and CTR4) may be used to provide mechanical isolation for the whole power supply system.

Specifically, the first end of the SCR1 may be connected to the first input terminal INPUT1 (or the first power supply S1), and the second end of the SCR1 may be connected to the first end of the mechanical switch CTR3. The second end of CTR3 may be connected to the power supply output terminal OUTPUT of the solid-state automatic transfer switch 100. When both SCR1 and CTR3 are turned on, the power supply output terminal OUTPUT of the solid-state automatic transfer switch 100 may gate and output the first power supply S1 to supply power to the load LOAD. Similarly, the first end of the SCR2 may be connected to the second input terminal INPUT2 (or the first power supply S2), and the second end of the SCR2 may be connected to the first end of the mechanical switch CTR4. The second end of CTR4 may be connected to the power supply output terminal OUTPUT of the solid-state automatic transfer switch 100. When both SCR2 and CTR4 are turned on, the power supply output terminal OUTPUT of the solid-state automatic transfer switch 100 may gate and output the second power supply S2 to supply power to the load LOAD.

In some embodiments, the isolation & inverter module 102 may include switches CTR1 and CTR2, an AC/DC Switching Mode Power Supply (SMPS) with an isolation function, a boost circuit BOOST and an inverter, for example, a Voltage Source Inverter (VSI).

Specifically, the first ends of CTR1 and CTR2 may be respectively connected to the first input terminal INPUT1 (or the first power supply S1) and the second input terminal INPUT2 (or the first power supply S2), and the second ends of CTR1 and CTR2 may be commonly connected to the input terminal of the AC/DC SMPS. Therefore, by controlling the switches of CTR1 and CTR2, an appropriate power supply may be selected for the isolation & inverter module 102. For example, when CTR1 is turned on and CTR2 is turned off, the first power supply S1 may be selected as the power supply for the isolation & inverter module 102.

The output terminal of AC/DC SMPS may be connected to the input terminal of the boost circuit BOOST. The boost circuit BOOST may boost the output voltage of AC/DC SMPS to adjust it to an expected amplitude. The output terminal of BOOST may be connected to the input terminal of VSI to invert the boosted DC source into an AC source. The output terminal of VSI may be connected to the power supply output terminal OUTPUT of the solid-state automatic transfer switch 100, so as to output the isolation & inverter power supply generated by VSI through the power supply output terminal OUTPUT under the control of the control module 103. Further, the AC/DC SMPS, BOOST and VSI may form a constant voltage inverter, and the output power of the constant voltage inverter may supply power to the load LOAD during the power switching process under the control of the control module 103.

It should be understood that the structure of the isolation & inverter module 102 as shown in FIG. 2 is just an example, and the isolation & inverter module 102 may be of any structure that may have an isolating and inverting function, which is not limited herein.

In addition, the control module 103 may be connected to a plurality of modules of the solid-state automatic transfer switch 100 to detect the circuit state at a specific location of the solid-state automatic transfer switch 100 and/or control operations of one or more modules of the solid-state automatic transfer switch 100. For example, the control module 103 may be connected to each module or to any circuit location as shown in FIG. 2. In order to avoid obscuring the embodiments of the present disclosure, connections related to the control module 103 are omitted in the drawings.

As an improvement of the traditional ATS, the solid-state ATS 100 shown in FIG. 2 still has a main function of switching from a master power supply (e.g., the first power supply S1) to a slave power supply (e.g., the second power supply S2). For this basic function, it is first necessary to know when to switch the power supply.

According to embodiments of the present disclosure, the control module 103 of the solid-state automatic transfer switch 100 may detect a circuit state (for example, the voltage and current between the power supply and the load, etc.) in real time, so as to determine whether switching is necessary. Different detection situations may correspond to different switching modes. A specific handover method according to embodiments of the present disclosure is as follows. Hereinafter, it is assumed that the current gated power supply is S1.
1. The control module 103 of the solid-state automatic transfer switch 100 may detect a voltage state of S1 (for example, a voltage state at INPUT1). When it is detected that one or more of overvoltage, undervoltage, power-off or frequency overrun (for example, exceeding a first threshold) occurs on S1, the system may switch by S1->VSI->S2.
2. The control module 103 of the solid-state automatic transfer switch 100 may detect a load state of S1 (for example, the load power at OUTPUT). When it is detected that S 1 is overloaded, and when a degree of overload of the system is lower than a second threshold (for example, the load power is less than 200% of a normal load power), the system may start the isolation & inverter module 102 (or VSI), and the VSI will output in a current source mode (for example, output the first isolation & inverter power supply), thus affecting the tide current, reducing the load of S1 and eliminating overload.
   In this case, the power-supplying loop of the system is shown by thick arrows PATH1 and PATH2 in FIG. 3. In this case, the power supply gating module 101 still maintains gating S1, where, for example, SCR1 and CTR3 are turned on, and SCR2 and CTR4 are turned off CTR1 in the isolation & inverter module 102 is turned off, CTR2 is turned on, and S2 is selected as the power supply for the power supply gating module 101 to generate the first isolation & inverter power supply as a current source through VSI. In this case, S 1 and the first isolation & inverter power supply supply power to the load LOAD through the power supply output terminal OUTPUT jointly.
3. As mentioned above, a first circuit breaker (not shown) may be further provided between the first input terminal INPUT1 and the first power supply S1, and a second circuit breaker (not shown) may be further provided between the power supply output terminal OUTPUT and the load LOAD. In this case, the control module 103 of the solid-state automatic transfer switch 100 may detect a current state of S1 (for example, the current state at the first end of the SCR1). When a detected current is greater than a third threshold (for example, a threshold corresponding to a short-circuit current), it can be determined that the system has a short circuit or an instantaneous surge. In this case, the system may maintain gating S 1, and protect the circuit by the second circuit breaker downstream or the first circuit breaker upstream (for example, at least one of the circuit breakers is turned off).
4. Similar to point 3 above, during the system operation, the control module 103 may detect a change speed (for example, di/dt) of the system current in real time. When it is detected that the current change speed is greater than a fourth threshold (for example, a threshold corresponding to a change speed of a short-circuit current), it can be determined that the system has a short circuit or an instantaneous surge. In this case, the system may maintain gating S1, and protect the circuit by the second circuit breaker downstream or the first circuit breaker upstream (for example, at least one of the circuit breakers is turned off).
5. The user may request switching from S1 to S2 by a manual instruction. For example, the control module 103 may receive a switching instruction from a user and perform power switching based on the switching instruction.

Further, after it is clear that the system needs to perform switching, an example switching process according to embodiments of the present disclosure is as follows (taking a switching process of the system from S1 to S2 as an example):
1. The initial state of the solid-state automatic transfer switch 100 is that the first power supply S1 is gated. At this time, SCR1 is turned on, the isolator 104 is in S1 branch (i.e., CTR3 is turned on and CTR4 is turned off), and CTR1 is turned off and CTR2 is turned on.
2. When power switching needs to be performed due to it is detected that the S1 source is abnormal (or according to a user's instruction), SCR1 is turned off, and meanwhile, the VSI inverts and outputs an inverter voltage (for example, a second isolation & inverter power supply). The initial amplitude of the inverter voltage may be slightly higher than that of the S1 source, so as to prompt SCR1 to quickly enter a turn-off state. In this case, in order to ensure the continuity of load power supply, the phase of the inverter voltage output by VSI may be consistent with the phase of S1 source.
3. Switch the isolator from S1 to S2 (that is, CTR3 is turned off and CTR4 is turned on). During this process, the system supplies power to the load by the inverter voltage output by the VSI.
4. VSI phase tracking. During the switching process from S1 to S2, if there is a difference between the phases of S1 and S2, VSI may slowly adjust the phase of the inverter voltage from S1 to S2. It should be understood by those skilled in the art that the term "slowly" as mentioned herein may correspond to any rate that does not cause load or circuit fluctuation.
5. VSI may also track the voltage amplitude at the same time. For example, when the amplitude of the inverter voltage output by VSI is the same as the amplitude of S2 and the phase is also the same as that of S2, the control module may turn on SCR2 and block the output of VSI at the same time.
6. Further, CTR2 may be turned off while CTR1 may be turned on. In this case, the example switching process ends, and the final state of the solid-state automatic transfer switch 100 is that the second power supply S2 is gated. At this time, SCR1 is turned off, SCR2 is turned on, isolator 104 is in S2 branch (that is, CTR3 is turned off and CTR4 is turned on), and CTR1 is turned on and CTR2 is turned off.

A switching process from S2 to S1 is the same as the switching process from S1 to S2, and will not be described herein.

FIG. 4 shows an example change process 400 of a load voltage during power switching according to embodiments of the present disclosure.

As shown in FIG. 4, before time T1, the load is powered by the source S1. At time T1, it may be detected that the voltage of the source S1 is abnormal and it is determined to perform power switching. At this time, the SCR of the source S1 may be turned off, and a voltage may be output by the VSI to supply power to the load. During the switching process from time T1 to time T2, as described above, the gear of the isolator may be switched from S1 to S2, and the VSI tracks the phase and amplitude of the source S2. At time T2, the amplitude of an inverter voltage output by VSI is the same as that of the source S2, and the phase of the inverter voltage is also the same as that of the source S2. At this time, SCR2 corresponding to source S2 may be turned on, and at the same time, the output of VSI may be blocked, CTR2 may be turned off and CTR1 may be turned on. At this point, the load voltage is successfully switched to the source S2.

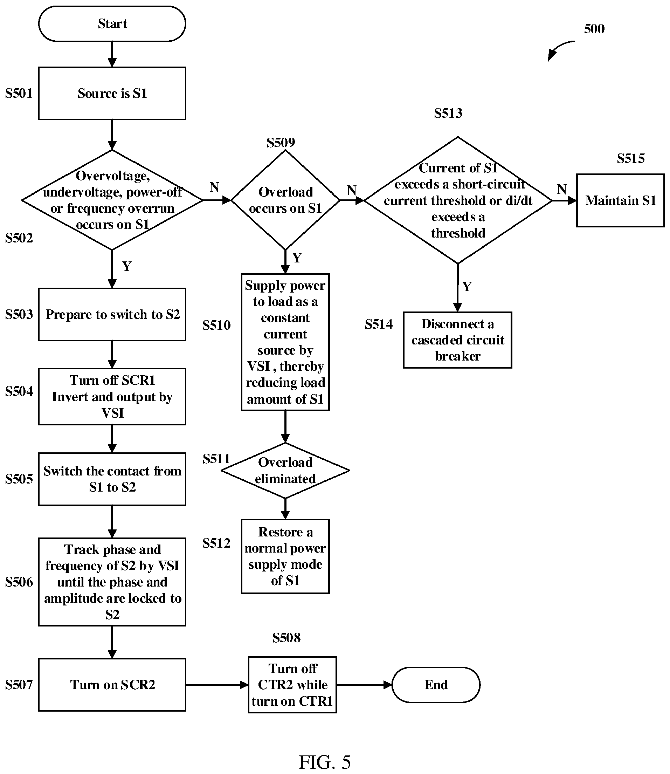

Further, FIG. 5 shows an example flowchart 500 of a power switching process according to embodiments of the present disclosure.

As shown in FIG. 5, in an initial state, for example, at step S501, the system is in a source S1 state. At step S502, the control module may detect whether one or more of overvoltage, undervoltage, power-off or frequency overrun occurs on S1. If so, the flow proceeds to step S503, where the system prepares to switch to S2. At step S504, SCR1 may be turned off, and the VSI inverts and outputs a second isolation & inverter power supply. At step S505, the contact of the isolator is switched from S1 to S2. At step S506, the inverter output of VSI may track the phase, frequency and amplitude of S2 until the phase and amplitude are locked to S2. At step S507, SCR2 is turned on. At step S508, CTR2 is turned off and CTR1 is turned on. At this time, the power switching process from S1 to S2 ends.

If the voltage abnormality of S1 is not detected at step S502, the flow may proceed to step S509, where the control module may detect whether overload occurs on S1. If so, the flow may proceed to step S510, where the VSI may supply power to the load as a constant current source, thereby reducing the load amount of S1. At step S511, the overload is eliminated. Next, at step S512, a normal power supply mode of S1 may be restored.

If overload on S1 is not detected at step S509, the flow may proceed to step S513, where the control module may monitor whether the current of S1 exceeds a short-circuit current threshold or whether the change speed of the current of S1 exceeds a short-circuit current change speed threshold. If so, the flow may proceed to step S514, where the circuit can be protected, for example, by disconnecting a circuit breaker cascaded with the solid-state automatic transfer switch; and if not, the flow may proceed to step S515, where the load power supply may be maintained at S1 for normal power supply.

It should be understood that the example flowchart 500 is only an example of a power switching process according to embodiments of the present disclosure. The steps in the example flowchart 500 may be performed in any other order. For example, the judgment steps of S502, S509 and S513 in the example flowchart 500 may be interchanged with each other or performed at the same time.

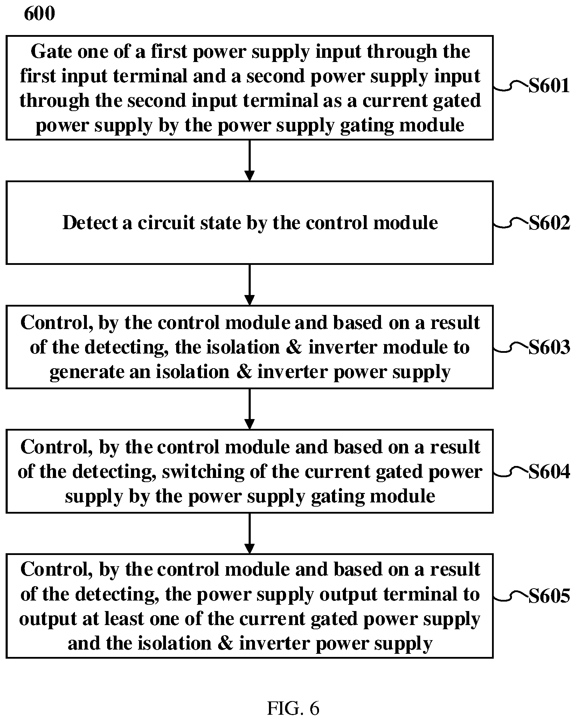

Next, FIG. 6 shows a flowchart of an operating method 600 of a solid-state automatic transfer switch according to embodiments of the present disclosure.

As described above, the solid-state automatic transfer switch according to embodiments of the present disclosure may include a first input terminal, a second input terminal, a power supply gating module, an isolation & inverter module, a control module and a power supply output terminal. Further, the operating method 600 of the solid-state automatic transfer switch according to embodiments of the present disclosure may include: at step S601, gating one of a first power supply input through the first input terminal and a second power supply input through the second input terminal as a current gated power supply by the power supply gating module; at step S602, detecting a circuit state by the control module; at step S603, controlling, by the control module and based on a result of the detecting, the isolation & inverter module to generate an isolation & inverter power supply; at step S604, controlling, by the control module and based on a result of the detecting, switching of the current gated power supply by the power supply gating module; and at step S605, controlling, by the control module and based on a result of the detecting, the power supply output terminal to output at least one of the current gated power supply and the isolation & inverter power supply.

It should be understood that the steps in the operating method 600 may be performed in any other order not shown, for example, in a reverse order or simultaneously. The operating method 600 of the solid-state automatic transfer switch according to embodiments of the present disclosure may further include any method or operation steps described above in connection with FIGs. 1 to 5, and will not be repeated herein.

The whole hardware computing device or its components described in the present disclosure may be realized by various suitable hardware means, including but not limited to FPGA, ASIC, SoC, discrete gate or transistor logic, discrete hardware components, or any combination thereof.

The block diagrams of circuits, apparatuses, devices, equipment and systems involved in the present disclosure are only illustrative examples, and are not intended to require or imply that they must be connected, arranged or configured in the manner shown in the block diagram. As will be recognized by those skilled in the art, these circuits, apparatuses, devices, equipment and systems may be connected, arranged or configured in any way, as long as a desired purpose can be achieved.

Although the present disclosure has been described with exemplary embodiments, various changes and modifications may be suggested to those skilled in the art. The present disclosure is intended to cover such changes and modifications as fall within the scope of the appended claims.

Any description in the present disclosure should not be understood as implying that any particular element, step or function is an essential element that must be included within the scope of the claims. The scope of the patent subject matter is defined only by the claims.

Exemplary embodiments according to the present disclosure have been disclosed herein, and although specific terms are employed, they are used and explained in a generic and descriptive sense only and not for the purpose of limitation. In some cases, features, characteristics and/or elements described in connection with a particular embodiment may be used alone or in combination with features, characteristics and/or elements described in connection with other embodiments, unless otherwise specified. Therefore, it will be understood by those skilled in the art that various changes in form and details can be made in the present disclosure without departing from the spirit and scope of the claims.

## Claims

1. A solid-state automatic transfer switch, comprising:
a first input terminal, configured to input a first power supply;
a second input terminal, configured to input a second power supply;
a power supply gating module, including a solid-state switch and configured to gate one of the first power supply and the second power supply as a current gated power supply;
an isolation & inverter module, configured to generate an isolation & inverter power supply based on control of a control module;
a control module, configured to detect a circuit state and control, based on a result of the detecting, switching of the current gated power supply by the power supply gating module; and
a power supply output terminal, configured to output at least one of the current gated power supply and the isolation & inverter power supply based on control of the control module.

2. The solid-state automatic transfer switch according to claim 1, wherein the detecting a circuit state and controlling, based on a result of the detecting, switching of the current gated power supply by the power supply gating module comprises:
detecting a voltage state of the current gated power supply, and
when it is detected that one or more of overvoltage, undervoltage, power-off or frequency exceeding a first threshold occurs on the current gated power supply, controlling the power supply gating module to switch the current gated power supply from one of the first power supply and the second power supply that is currently gated to one of the first power supply and the second power supply that is not currently gated.

3. The solid-state automatic transfer switch according to claim 1, wherein the detecting a circuit state and controlling, based on a result of the detecting, switching of the current gated power supply by the power supply gating module comprises:
detecting a load state of the current gated power supply, and
when it is detected that the current gated power supply is overloaded and a degree of overload is lower than a second threshold, controlling the power supply gating module to maintain the current gated power supply, and controlling the isolation & inverter module to generate a first isolation & inverter power supply,
wherein the current gated power supply and the first isolation & inverter power supply are jointly output through the power supply output terminal.

4. The solid-state automatic transfer switch according to claim 3, wherein the isolation & inverter module generates the first isolation & inverter power supply in a current source mode.

5. The solid-state automatic transfer switch according to claim 1, wherein a first circuit breaker is further provided between the first input terminal and the first power supply, and a second circuit breaker is further provided between the power supply output terminal and a load, wherein the detecting a circuit state and controlling, based on a result of the detecting, switching of the current gated power supply by the power supply gating module comprises:
detecting a current state of the current gated power supply, and
when it is detected that an operating current of the current gated power supply is greater than a third threshold and/or a change speed of the operating current is greater than a fourth threshold, controlling the power supply gating module to maintain the current gated power supply, wherein a circuit is protected by disconnecting of at least one of the first circuit breaker and the second circuit breaker.

6. The solid-state automatic transfer switch according to claim 1, wherein the control module is further configured to:
receiving a switching instruction, and
based on the switching instruction, controlling the power supply gating module to switch the current gated power supply from one of the first power supply and the second power supply that is currently gated to one of the first power supply and the second power supply that is not currently gated.

7. The solid-state automatic transfer switch according to claim 1, wherein the control module is further configured to:
control, during a switching process of the current gated power supply, the power supply gating module to turn off the gating of the current gated power supply, and control the isolation & inverter module to generate a second isolation & inverter power supply for supplying power to a load during the switching process.

8. The solid-state automatic transfer switch according to claim 7, wherein an initial voltage amplitude of the second isolation & inverter power supply is higher than that a voltage amplitude of the current gated power supply, and a voltage amplitude of the second isolation & inverter power supply is adjusted to be the same as a voltage amplitude of an input power supply to be switched to during the switching process.

9. The solid-state automatic transfer switch according to claim 7, wherein an initial phase of the second isolation & inverter power supply is the same as a phase of the current gated power supply, and a phase of the second isolation & inverter power supply is adjusted to be the same as a phase of an input power supply to be switched to at a first rate during the switching process.

10. The solid-state automatic transfer switch according to claim 7, wherein the control module is further configured to:
when a voltage amplitude of the second isolation & inverter power supply is the same as a voltage amplitude of an input power supply to be switched to and a phase of the second isolation & inverter power supply is the same as a phase of the input power supply to be switched to, controlling the power supply gating module to gate the input power supply to be switched to, and controlling the isolation & inverter module to terminate the output of the second isolation & inverter power supply.

11. An operating method of a solid-state automatic transfer switch which comprises a first input terminal, a second input terminal, a power supply gating module, an isolation & inverter module, a control module and a power supply output terminal, the operating method comprising:
gating, by the power supply gating module, one of a first power supply input through the first input terminal and a second power supply input through the second input terminal as a current gated power supply;
detecting, by the control module, a circuit state;
controlling, by the control module and based on a result of the detecting, the isolation & inverter module to generate an isolation & inverter power supply;
controlling, by the control module and based on a result of the detecting, switching of the current gated power supply by the power supply gating module; and
controlling, by the control module and based on a result of the detecting, the power supply output terminal to output at least one of the current gated power supply and the isolation & inverter power supply.
